# EUROPÄISCHE PATENTANMELDUNG

(11) **EP 2 458 626 A1**
(43) Veröffentlichungstag der Anmeldung: **30.05.2012**
(21) Anmeldenummer: 11009415.8
(22) Anmeldetag: 29.11.2011
(51) Int. Cl.: H01L 21/67, B28D 5/00

(54) **Halte-Reinigungsvorrichtung und Verfahren zum abschnittweisen Reinigen gesägter Wafer**

(30) Priorität: 29.11.2010 DE 102010052635
(71) Anmelder: RENA GmbH, 78148 Gütenbach (DE)
(72) Erfinder: Dechant-Wagner, Roland, 78056 Villingen-Schwenningen (DE)
(74) Vertreter: Stürken, Joachim

(57) **Zusammenfassung**

Die Erfindung betrifft eine Vorrichtung zum kombinierten Halten und Reinigen von flachen Substraten, die mittels Sägens aus einem Block hergestellt sind, sowie ein Verfahren dazu.

Eine erfindungsgemäße Vorrichtung dient dem Halten eines zu sägenden Substratblocks (13A, 13B) dem Spülen der durch das Sägen des Substratblocks (13A, 13B) entstandenen Zwischenräume. Sie umfasst zwei parallel zur Vorrichtungs-Längsachse (L) und übereinander angeordneten Bereiche, wobei der obere Bereich als Adapterbereich (1) ausgestaltet ist, über den die Vorrichtung mit einer maschinellen Einrichtung verbindbar ist, und wobei der untere Bereich als Haltebereich (2) ausgebildet ist, der einen als Kanal (11) vorliegenden Teil eines über verschließbare Versorgungsöffnungen (5) mit Spülflüssigkeit speisbaren und umlaufend geschlossenen oder verschließbaren Kanalsystems aufweist, wobei der Boden des Kanals (11) beim Sägen des Substratblocks (13A, 13B) unter Schaffung von Durchtrittsöffnungen (15) für die Spülflüssigkeit schlitzartig geöffnet wird, und wobei der Kanal (11) entlang der Vorrichtungs-Längsachse (L) in mehrere Abschnitte (11A, 11B) unterteilt ist.

Das erfindungsgemäße Verfahren zum Spülen der durch das Sägen eines Substratblocks (13A, 13B) entstandenen Zwischenräume ist gekennzeichnet durch eine Verwendung einer vorstehend beschriebenen Vorrichtung.

## Beschreibung

### Einleitung

Die Erfindung betrifft eine Vorrichtung zum kombinierten Halten und Reinigen von flachen Substraten, die mittels Sägens aus einem Block hergestellt sind, sowie ein Verfahren dazu. Insbesondere betrifft die Erfindung das Halten und Reinigen flacher Siliziumsubstrate, nachfolgend auch kurz Wafer genannt, welche aus einem auch Ingot genannten Block aus mono- oder polykristallinem Silizium gesägt vorliegen.

Unter dem Begriff "Wafer" werden erfindungsgemäß scheibenförmige Gegenstände verstanden, die eine im Vergleich zu ihren übrigen Abmessungen sehr geringe Dicke aufweisen, die typischerweise im Bereich zwischen 80 und 300 µm und insbesondere zwischen 150 und 170 µm liegt. Die lateralen Abmessungen betragen hingegen beispielsweise 125 x 125mm (5-Zoll-Wafer) oder mehr. Die Form der Scheiben ist beliebig und kann beispielsweise im Wesentlichen rund sein (Halbleiterwafer) und eine optionale Kante aufweisen, die die Kristallorientierung anzeigt (Waferflat), oder im Wesentlichen rechteckig bzw. quadratisch sein (Solarwafer), wobei die Ecken dann wahlweise winklig, abgerundet oder abgeschrägt ausgestaltet sein können. Die beschriebenen Gegenstände sind aufgrund der Kombination aus geringer Dicke mit geringer Elastizität sehr bruchempfindlich.

### Stand der Technik und Nachteile

Zur Herstellung der Wafer wird zunächst der Block auf einer Trägerplatte fixiert. Diese besteht typischerweise aus Glas und ist je nach Form des Blocks eben oder gewölbt. Zum Fixieren wird gewöhnlich ein Kleber verwendet. Die Trägerplatte wird ihrerseits auf einer Adapterplatte angebracht, die typischerweise aus Metall besteht. Die Adapterplatte ist dabei so ausgestaltet, dass sie mit einer Gegenfläche zusammenwirkt, die Teil der Abtrennvorrichtung (Wafersäge) ist. Nach dem Befestigen der Adapterplatte an der Gegenfläche kann der Block mit der Abtrennvorrichtung wie beispielsweise einer Drahtsäge bearbeitet werden, die typischerweise einen oder auch mehrere, parallel verlaufende Schneiddrähte umfasst. Dabei werden aus dem Block dünne Scheiben hergestellt, die aufgrund des Klebers mit ihrer dem Träger zugewandten Kante (Klebekante) an der Trägerplatte hängen. Die aufeinander folgend angeordneten Scheiben sind demnach über die Trägerplatte noch miteinander verbunden. Zum vollständigen Abtrennen eines Wafers vom Block muss die Abtrennvorrichtung ein Stück in die Trägerplatte schneiden, in welche dabei eingeschnitten wird und somit nicht für eine Wiederverwendung geeignet ist.

Nachdem ein Längsabschnitt des Blocks vollständig in einzelne Wafer zerteilt worden ist und sich zwischen den einzelnen Wafern somit ein spaltartiger Zwischenraum gebildet hat, liegt dieser Längsabschnitt in Form eines kammartigen, fächerartigen Gebildes vor, das auch "Waferkamm" genannt wird. Vorzugsweise wird der Waferkamm in an der Trägerplatte hängender Orientierung gehandhabt, was insbesondere auch für nachfolgende Reinigungsschritte gilt.

Aus Gründen der Wirtschaftlichkeit werden häufig mehrere, kurze Blöcke hintereinander auf eine Trägerplatte aufgeklebt und nachfolgend gesägt. Somit entfällt das mehrfache Ein- und Ausspannen der Werkstücke.

Zum Entfernen der Abraumpartikel ist am Sägeprozess eine Slurry genannte Suspension beteiligt, die typischerweise aus Trägerflüssigkeit und ggf. Siliziumkarbid sowie weiteren Additiven besteht. Diese Suspension haftet unerwünschterweise an der Waferoberfläche, und setzt sich in den Zwischenräumen fest. Dies gilt sowohl dann, wenn als Trennmittel Siliziumkarbid verwendet wird, als auch in Fällen, in denen diamantbesetzte Sägedrähte zum Einsatz kommen. Zur weiteren Prozessierung müssen die gesägten Wafer sowohl von der Klebeschicht abgenommen und vereinzelt, als auch gereinigt werden. Eine Reinigung, jedenfalls eine Vorreinigung, sollte dabei bereits möglichst frühzeitig, insbesondere noch vor dem Ablösen des Klebers, erfolgen. Auf diese Weise wird ein verstärktes Anhaften der im getrockneten Zustand sehr festen Slurry vermieden. Auch sind die Schlieren, die sich an den Rändern der einmal getrockneten Slurry bilden, praktisch nicht mehr entfernbar und können im Extremfall zu einer Unbrauchbarkeit des Wafers führen. Zudem verunreinigt die Slurry aufgrund der Verschleppung nachfolgende Prozessbäder, was ebenfalls unerwünscht ist.

Eine Reinigungsvorrichtung für derartige, noch an der Halteplatte befestigte Wafer ist beispielsweise in der Druckschrift WO 2009/074297A2 gezeigt. Hier wird der vollständig gesägte Block mittels einer seitlich des gesägten Blocks angeordneten Duscheinrichtung abgespült. Der Strahl der Reinigungsflüssigkeit ist dabei seitlich in die spaltartigen Zwischenräume gerichtet. Problematisch dabei ist die Tatsache, dass der mittige Bereich der Klebekante nur unzureichend erreichbar ist. Daraus folgt entweder eine entsprechend lange Reinigungszeit, oder eine unvollständige Vorreinigung. Zur Verbesserung des Reinigungsergebnisses wird daher ein alternierendes Sprühen von beiden Seiten, ein relative Bewegbarkeit zwischen Träger und Duscheinrichtung sowie eine Unterstützung durch Gasblasen und/oder Ultraschall vorgeschlagen. Das auf obiger Druckschrift aufbauende Dokument EP 1935514 schlägt zusätzlich eine verschwenkende Bewegbarkeit der Duscheinrichtung vor. Auch dadurch wird die oben genannte Problematik jedoch nicht zufriedenstellend gelöst.

Um dem Problem der schlechten Ausspülbarkeit zu begegnen, schlägt die EP 2153960 A2 vor, mindestens einen Durchlass zum Zuführen eines Spülfluids zwischen die am Träger hängenden Wafer vorzusehen. Aufgrund des auf das Sägen folgenden Beaufschlagens des Durchlasses tritt das Spülfluid durch einen einzigen Längsspalt, durch mehrere Querspalte oder durch Bohrungen des Durchlasses in Richtung der Zwischenräume des Waferkamms aus. Diese werden somit in ihrer Gesamtheit von den oben genannten Rückständen gereinigt. Der Längsspalt, die Querspalte oder Bohrungen im Durchlass sind dabei typischerweise jederzeit, also auch vor und nach nur teilweisem Sägen des Blocks, im Träger vorhanden. Alternativ können die Querspalte auch erst durch den Sägeprozess selber erzeugt werden. Dabei besteht das den Durchlass formende Material gewöhnlich aus einem weicheren Material als der Rest der Vorrichtung, um den Sägedraht während des Einschnitts möglichst gering zu beanspruchen. Eine ähnliche Vorrichtung ist in der Druckschrift EP 2 111 960 A1 beschrieben, wo mehrere zueinander parallele sowie quer zur Längsachse der Haltevorrichtung verlaufende, gemeinsam speisbare Kanäle ("channels") gezeigt sind.

Aufgrund der Tatsache, dass der Durchlass bzw. die Kanäle nur als Ganzes mit Reinigungsfluid beaufschlagt werden kann bzw. können, tritt dieses auch gleichzeitig durch den gesamten Längsspalt, die Bohrungen bzw. ggf. durch das Sägen eingebrachten Querspalte in Richtung der Waferzwischenräume aus. Daraus resultiert unter Umständen eine ungleichmäßige Reinigungswirkung, da der Druck und somit das ausströmende Fluidvolumen bei zunehmender Länge des Durchlasses abnimmt. Die daraus resultierende ungleichmäßige Reinigungswirkung und der Verlust an ungenutztem Reinigungsfluid ist unbefriedigend. Um eine effektive Nutzung des Reinigungsfluids gewährleisten zu können, muss zum Reinigen mit einer Lanze o.Ä. gearbeitet werden. Nur lokal im Bereich der Lanzenspitze ist der Druckabfall minimal, der Volumenstrom maximal, und somit die erwünschte Reinigungswirkung erzielbar. Durch Bewegen der Lanzenspitze entlang der Längserstreckung des Durchlasses erfolgt die Reinigung der jeweiligen Waferzwischenräume im Wesentlichen sequenziell und somit zeitintensiv. Zudem wird für die dazu notwendige Vorrichtung eine aufwändige Technik benötigt. Eine technisch einfachere Lösung sieht vor, externe Versorgungsdüsen an die entsprechende Anschlussöffnung des Durchlasses anzupressen, um eine ausreichende Dichtwirkung zum Durchlass zu erreichen. Wegen des dort genutzten weichen Materials (s.o.) treten dabei jedoch häufig Beschädigungen an der Anschlussöffnung auf, da der Druck und Volumenstrom aufgrund des durchgehenden Durchlasses hoch sein muss. Ein weiterer Nachteil ist darin begründet, dass in Fällen, in denen lediglich ein Abschnitt des Trägers mit einem Block verbunden ist, trotzdem über die gesamte Länge der Zuführung Reinigungsfluid austritt. Auch daraus resultiert eine ineffektive Nutzung des Reinigungsfluids.

### Aufgabe der Erfindung und Lösung

Die Aufgabe der Erfindung ist daher die Sicherstellung einer gleichmäßigen Verteilung und effektiven Nutzung der Reinigungsflüssigkeit entlang der gesamten Längserstreckung des Trägers. Die Ausbringung der Reinigungsflüssigkeit soll optional schon während dem Vorhandensein des Blocks in der Säge möglich sein, ohne dass eine Beeinträchtigung des Sägevorgangs zu befürchten ist. Die zur Erreichung dieser Ziele benötigte Vorrichtung soll möglichst einfach sein.

Die Aufgabe wird durch eine Vorrichtung gemäß Anspruch 1, und durch ein Verfahren zur Reinigung gemäß Anspruch 9 gelöst. Bevorzugte Ausführungsformen sind in den Unteransprüchen, der nachfolgenden Beschreibung, sowie in den Figuren enthalten.

### Beschreibung

Nachfolgend wird die erfindungsgemäße Vorrichtung detailliert beschrieben. Im Anschluss findet sich eine Beschreibung des erfindungsgemäßen Verfahrens.

Die erfindungsgemäße Vorrichtung dient dem Halten eines zu sägenden Substratblocks und zum Spülen der durch das Sägen des Substratblocks entstandenen Zwischenräume mit zwei parallel zur Vorrichtungs-Längsachse und übereinander angeordneten Bereichen, wobei der obere Bereich als Adapterbereich ausgestaltet ist, über den die Vorrichtung mit einer maschinellen Einrichtung verbindbar ist, und wobei der untere Bereich als Haltebereich ausgebildet ist, der einen als Kanal vorliegenden Teil eines über verschließbare Versorgungsöffnungen mit Spülflüssigkeit speisbaren und umlaufend geschlossenen oder verschließbaren Kanalsystems aufweist, wobei der Boden des Kanals beim Sägen des Substratblocks unter Schaffung von Durchtrittsöffnungen für die Spülflüssigkeit schlitzartig geöffnet wird, und wobei der Kanal entlang der Vorrichtungs-Längsachse in mehrere Abschnitte unterteilt ist.

Das erfindungsgemäße Halten erfolgt bevorzugt in einer Position, in welcher der Substratblock bzw. die daraus hergestellten Substrate hängend angeordnet sind. Besonders bevorzugt sind diese Gegenstände mittels einer Klebeschicht an der erfindungsgemäßen Vorrichtung befestigt. Alternativ oder zusätzlich ist auch eine Klemmung der Gegenstände möglich.

Wenngleich die Vorrichtung primär dem Spülen der o.g. Zwischenräume dient, kann sie auch zur Reinigung oder jedenfalls zur Vorreinigung der Oberflächen der gesägten Substrate dienen. Typischerweise erfolgt eine derartige Reinigung jedoch mittels anderer Vorrichtungen (vgl. obige Ausführungen zum Stand der Technik).

Die gesägten Substrate sind nach dem Sägen in Vorrichtungs-Längsachse hintereinander angeordnet. Somit weist die Vorrichtungs-Längsachse in Richtung der Flächennormalen der Substrate. Typischerweise weist die Vorrichtung eine Länge auf, welche größer als die Breite der Vorrichtung ist. Sie hat demnach eine obere und untere Flachseite, eine vordere und hintere Stirnseite, sowie eine rechte und linke Seite.

Die Lagebezeichnungen des "oberen" und "unteren" Bereichs dienen dabei lediglich der beschreibungsmäßigen Orientierung. Die Vorrichtung kann ebenso umgekehrt aufgebaut sein, ohne vom erfinderischen Gedanken abzuweichen. Der Begriff "übereinander" deutet an, dass die beiden Bereiche jeweils mindestens eine Fläche aufweisen, die im Verhältnis zu den übrigen Außenflächen (Seitenflächen) größer ist. Somit können beide Bereiche an diese Fläche angrenzen.

Der "Adapterbereich" ist so ausgestaltet, dass er an einer maschinellen Einrichtung, insbesondere der Vorschubeinrichtung einer Wafersäge, angebracht werden kann. Es ist klar, dass dieser Bereich dazu besonders bevorzugt entsprechende geometrische Merkmale wie richtig positionierte Löcher / Bohrungen, Anschläge, Aufnahmen für eine Schienenführung etc. aufweisen kann. Ebenfalls bevorzugt ist, dass dieser Bereich aus einem harten, festen und sowohl mechanisch als auch chemisch unempfindlichen Material wie z.B. Edelstahl oder Keramik hergestellt ist.

Der "Haltebereich" dient der Befestigung der Vorrichtung mit dem Substratblock (s.o.). Es sei angemerkt, dass es sich hierbei zunächst nur um zwei funktionell unterschiedliche Bereiche handelt, so dass die Vorrichtung als solche durchaus einstückig hergestellt sein kann.

Erfindungsgemäß weist der Haltebereich einen als Kanal vorliegenden Teil eines Kanalsystems auf, durch welchen Spülflüssigkeit in Richtung der o.g. Zwischenräume ausgebbar ist. Der Begriff "Kanalsystem" deutet an, das es sich dabei um einen einzelnen, zusammenhängenden Kanal, oder auch eine Mehrzahl voneinander unabhängiger Einzelkanäle handeln kann. Es ist klar, dass das Kanalsystem Versorgungsöffnungen aufweisen muss, durch welche die Spülflüssigkeit in das Kanalsystem einfließen kann. Dabei sind erfindungsgemäß mehrere dieser Versorgungsöffnungen vorhanden, die jedoch verschließbar sind. Auf diese Weise ist der Ort, an welchem die Reinigungsflüssigkeit in das Kanalsystem eingespeist wird, flexibel wählbar. Damit die Reinigungsflüssigkeit nicht an unerwünschter Stelle aus dem Kanalsystem austritt, ist o.g. Verschließbarkeit vorgesehen. Dadurch ist im Prinzip ein umlaufend geschlossenes Kanalsystem herstellbar, wobei "umlaufend" die beiden Seiten sowie die vordere und hintere Stirnfläche einer eher flächig ausgebildeten erfindungsgemäßen Vorrichtung meint. Nicht gemeint sind hingegen die Ober- und Unterseite der Vorrichtung, Es ist auch klar, dass die Versorgungsbohrungen nicht auf der dem Substratblock zugewandten Seite (Unterseite der Vorrichtung) angeordnet sein sollten. Es sei außerdem angemerkt, dass das Kanalsystem nicht ausschließlich im Haltebereich angeordnet sein muss. Es kann durchaus auch Abschnitte umfassen, die im oberen Bereich verlaufen. Es ist sogar möglich, dass das Kanalsystem zum Adapterbereich hin offen liegt, und erst durch Anbringen an der maschinellen Einrichtung entsprechend gedichtet und somit zu einem "Kanalsystem" wird. Wesentlich ist lediglich, dass das Kanalsystem und insbesondere der Kanal Abschnitte umfasst, welche in den Haltebereich hineinragen und dazu geeignet sind, die Reinigungsflüssigkeit an die gewünschten Stellen an der Außenseite des Haltebereichs zu leiten. Diese Stellen befinden sich im Boden des Kanals, der Teil des Kanalsystems ist, also in dem Bereich, der zur Außenseite des Haltebereichs weist. Die Stellen werden erfindungsgemäß beim Sägen des Substratblocks unter Schaffung von Durchtrittsöffnungen für die Spülflüssigkeit schlitzartig geöffnet.

Aus der beschriebenen, erfindungsgemäßen Verwendung eines umlaufend verschließbaren oder verschlossenen Kanalsystems resultiert eine gleichmäßigere Spülwirkung der Zwischenräume, da keine Reinigungsflüssigkeit mehr an unerwünschter Stelle aus dem Kanalsystem austritt. Der Druck ist innerhalb des Kanalsystems und insbesondere innerhalb des o.g. Kanals im Wesentlichen konstant, und somit nimmt auch das ausströmende Flüssigkeitsvolumen bei zunehmender Entfernung von der Versorgungsöffnung nicht mehr ab. Daraus resultiert eine gleichmäßigere Spülwirkung, und der Verlust an ungenutzter Spülflüssigkeit ist signifikant geringer. Der anzulegende Druck kann im Vergleich zu einem (beidseitig) offenen Durchlass gering sein. Das aus dem Stand der Technik bekannte Bewegen einer Lanzenspitze entlang der Längserstreckung eines Zuführkanals entfällt, ebenso der Flüssigkeitsverlust durch den aufgrund der Bewegbarkeit derselben notwendigen Bewegungsspalt.

Erfindungsgemäß ist vorgesehen, dass der Kanal entlang der Vorrichtungs-Längsachse in mehrere Abschnitte unterteilt ist.

Bevorzugt sind diese Abschnitte unabhängig voneinander mit Spülflüssigkeit speisbar. Mit anderen Worten kann ein bestimmter Abschnitt (Sub-Kanal) des (Haupt-)Kanals, der besonders bevorzugt ein Längsabschnitt ist, und sich somit in Vorrichtungs-Längsachse erstreckt, unabhängig von einem bzw. mehreren anderen Abschnitten individuell mit Spülflüssigkeit beaufschlagt werden. Dadurch ergibt sich unter Anderem der Vorteil, dass der Verlust an Spülflüssigkeit weiter verringert werden kann, sofern ein Substratblock zu spülen ist, der sich nicht über die gesamte Länge der Vorrichtung erstreckt.

Nach einer Ausführungsform ist der (Haupt-)Kanal in bzw. durch mehrere baulich getrennte und unabhängig voneinander speisbare (Sub-)Kanäle unterteilt. Diese Kanäle können nebeneinander, bevorzugt jedoch in Vorrichtungs-Längsachse gesehen hintereinander angeordnet sein. Die Zuführungen führen dabei an separate Versorgungsöffnungen. Diese wiederum sind bevorzugt an der gleichen Seite der Vorrichtung angeordnet, beispielsweise an der hinteren Stirnfläche.

Nach einer anderen Ausführungsform ist der Kanal durch mehrere flüssigkeitshemmende oder flüssigkeitsblockierende (den Kanal abdichtende), lösbar im Kanalsystem eingebrachte Barrieren unterteilt. Das bedeutet, dass ein zunächst durchgehender Kanal, der sich wiederum bevorzugt in Vorrichtungs-Längsachse erstreckt, durch Objekte unterbrechbar oder unterbrochen ist, welche an verschiedenen, bevorzugt an beliebigen Stellen der Längserstreckung des Kanals in diesen eingebracht werden können bzw. sind. Besonders bevorzugt weist der Kanal auf seiner Innenwand positive oder negative Geometriemerkmale wie Vorsprünge oder Ausfräsungen auf, mit welchen die Objekte formschlüssig zusammenwirken. Auch das Zusammenwirken durch Kraftschluss an einer beispielsweise glatten Kanalinnenwand ist denkbar. Die Objekte können dazu besonders bevorzugt nachgiebig ausgestaltet sein. Beispielsweise können sie aus elastischem Material bestehen oder dieses umfassen, oder den Kraftschluss mittels Klammer- oder Federmechanismus erlauben. Selbstverständlich sind auch Kombinationen beider Varianten (Kraft- und Formschluss) möglich.

Nach einer besonders einfachen Ausführungsform weist der betreffende Kanal an seiner Innenwand zum Kanalinnenraum weisende, in einer Draufsicht in etwa dreieckige Vorsprünge auf, die in entsprechende Aussparungen der Objekte, die ansonsten die Form eines flachen Plättchens haben, eingreifen. Nach einer anderen, ähnlichen Ausführungsform weisen die Objekte selber entsprechende Vorsprünge auf.

Nach einer bevorzugten Ausführungsform sind die verschließbaren Versorgungsöffnungen an der oberen Flachseite des Adapterbereichs angeordnet. Diese Seite weist erfindungsgemäß in Richtung der maschinellen Einrichtung. Demnach trägt die maschinelle Einrichtung selber entsprechend angeordnete Öffnungen, aus denen die Spülflüssigkeit ausgebbar ist. Auf diese Weise ist eine besonders einfache fluidische Kopplung der erfindungsgemäßen Vorrichtung mit den externen Versorgungsleitungen möglich. Es ist klar, dass die Positionen der Öffnungen der maschinellen Einrichtung mit den Versorgungsöffnungen der erfindungsgemäßen Vorrichtung zumindest teilweise übereinstimmen müssen. Es ist auch klar, dass zwecks verbesserter Dichtigkeit Dichtungen in die Versorgungsöffnungen und/oder die Öffnungen in der maschinellen Einrichtung eingesetzt sein können.

Nach einer anderen Ausführungsform sind die Außenanschlüsse der verschließbaren Versorgungsöffnungen an der umlaufenden Seite des Adapterbereichs angeordnet. Dies sind die vordere und hintere Stirnseite und die rechte und linke Seite der Vorrichtung. Auch hier ist zu erwähnen, dass die Versorgungsöffnungen besonders bevorzugt im Adapterbereich, und nicht im Haltebereich angeordnet sind. Der Vorteil bei dieser Anordnung liegt darin begründet, dass das Material, aus welchem der Haltebereich besteht, unter Umständen weniger widerstandsfähig ist als das Material des Adapterbereichs. Durch die Anordnung der Versorgungsöffnungen im Adapterbereich wird sichergestellt, dass sich diese in einem für mechanische Bearbeitung und Belastung geeigneten Material befinden. Es ist klar, dass im Inneren der Vorrichtung geeignet verlaufende Kanalabschnitte vorhanden sind, die von den am Adapterbereich angeordneten Versorgungsöffnungen zu dem bevorzugt im Haltebereich verlaufenden Kanalsystem führen. Es ist auch klar, dass bei abschnittsweiser Speisbarkeit eines Kanals, bzw. bei separater Speisbarkeit einzelner Kanäle entsprechend separate Versorgungsöffnungen vorhanden sein müssen.

Alternativ oder zusätzlich zu den vorstehenden Ausführungsformen mit abschnittsweiser Speisbarkeit kann die Versorgung auch über eine einzelne Versorgungsöffnung erfolgen, und Ventile, Schieber oder dergleichen, die im Inneren der erfindungsgemäßen Vorrichtung angeordnet und von außen betätig- oder steuerbar sind, erlauben ein Dirigieren des Spülflüssigkeitsstroms in den oder die gewünschten Kanäle bzw. Kanalabschnitte.

Eine Ausführungsform sieht vor, dass der Haltebereich als Halteplatte und der Adapterbereich als Adapterplatte ausgebildet sowie beide Platten lösbar miteinander verbunden sind. Mit anderen Worten spiegelt sich nach dieser Ausführungsform die bisher rein funktionale Trennung des Adapterbereichs und des Haltebereichs auch durch die Bereitstellung zweier separater Komponenten wider. Es ist klar, dass diese Komponenten zur Erfüllung ihrer Aufgabe fest miteinander verbunden sein müssen. Dabei ist ebenfalls klar, dass eine Lösbarkeit gegeben ist, damit der beim Sägen des Substratblocks "verbrauchte" Teil der Vorrichtung, nämlich der Haltebereich, leicht ersetzt werden kann. Zudem ist auf diese Weise eine einfache Zugänglichkeit des Kanalsystems möglich. Somit ist je nach Bedarf eine individuelle Gestaltung der Kanalabschnitte möglich, die sich an der Bestückung mit einzelnen Substratblöcken unterschiedlicher Länge orientiert.

Nach einer weiteren Ausführungsform ist das Material des Haltebereichs, bzw. sofern vorhanden der Halteplatte, aus der Gruppe bestehend aus Glas, Kunststoff, Epoxid, Keramik, Metall, sowie Mischungen davon ausgewählt. Besonders bevorzugt ist die Verwendung von Glas, Kunststoff oder Epoxid. Die Verwendung von Metall ist weniger bevorzugt, da dieses Material gewöhnlich weniger leicht zu sägen ist als die übrigen aufgeführten Materialien. Wesentlich ist, dass das Material leicht sägbar ist, dass beim Sägen keine Partikel entstehen, welche den Bearbeitungsprozess stören oder das Ergebnis beeinträchtigen, dass das Material ausreichend fest ist, um die mechanischen Belastungen beim Ankleben und Sägen des Substratblocks aufzunehmen, und dass die Herstellkosten möglichst gering sind.

Die Erfindung betrifft neben einer Vorrichtung auch ein Verfahren zum Spülen der durch das Sägen eines Substratblocks entstandenen Zwischenräume unter Verwendung einer im Rahmen der vorstehenden Beschreibung offenbarten Vorrichtung, bei dem eine Beaufschlagung des als Kanal vorliegenden Teils eines Kanalsystems mit einer Spülflüssigkeit und ein Austritt derselben aus den Durchtrittsöffnungen erfolgt.

Eine Vorrichtung, die zur Durchführung des erfindungsgemäßen Verfahrens besonders geeignet ist, weist demnach zwei parallel zur Vorrichtungs-Längsachse und übereinander angeordnete Bereiche auf, wobei der obere Bereich als Adapterbereich ausgestaltet ist, über den die Vorrichtung mit einer maschinellen Einrichtung verbindbar ist.

Im unteren, als Haltebereich ausgebildeten Bereich ist ein als Kanal mit mehreren, in Vorrichtungs-Längsachse verlaufenden Abschnitten vorliegender Teil eines umlaufend geschlossenes Kanalsystem angeordnet, welches in einem ersten Schritt über verschließbare Versorgungsöffnungen mit Spülflüssigkeit gespeist wird.

In einem zweiten Schritt erfolgt ein Spülen der Zwischenräume mittels schlitzartiger Durchtrittsöffnungen für die Spülflüssigkeit, welche beim Sägen des Substratblocks im Boden des Kanals geschaffen worden sind.

Zur Vermeidung von Wiederholungen betreffend die Vorrichtungsbestandteile wird im Übrigen auf obige Beschreibung der erfindungsgemäßen Vorrichtung verwiesen.

Erfindungsgemäß erfolgt das Spülen aus den mit Spülflüssigkeit gespeisten Durchtrittsöffnungen entlang der Vorrichtungs-Längsachse gleichmäßig. Dies ist ein Resultat der Tatsache, dass sich im umlaufend geschlossenen Kanalsystem ein gleichmäßiger Druck aufbaut, welcher zu einem gleichmäßigen Austritt der Spülflüssigkeit aus den dafür vorgesehenen schlitzartigen Öffnungen führt.

Nach einer besonders bevorzugten Ausführungsform erfolgt die Speisung des Kanals und das Spülen der Zwischenräume mittels der Durchtrittsöffnungen in Vorrichtungs-Längsachse gesehen abschnittsweise. Das bedeutet, dass nicht das gesamte Kanalsystem und somit alle mit diesem verbundenen Durchtrittsöffnungen zugleich zum Spülen Verwendung finden, sondern dass je nach Bedarf Teile des Kanals von Flüssigkeit durchspült werden, so dass auch ein gezieltes Spülen von Substratblöcken bzw. aus diesen hergestellten Substratverbünden möglich ist, die eine geringere Länge als die Vorrichtung selber haben.

Das abschnittsweise Spülen kann wahlweise dadurch erreicht werden, dass mehrere, separat mit Reinigungsflüssigkeit beaufschlagbare Versorgungsöffnungen vorhanden sind, und/oder dass im Inneren der Vorrichtung Einrichtungen vorhanden sind, welche ein Auswahl des jeweils gewünschten Kanals bzw. Kanalabschnitts erlauben.

Nach einer weiteren Ausführungsform erfolgt das Spülen im Arbeitsbereich einer Trennvorrichtung für den Substratblock wie beispielsweise einer Wafersäge. Das bedeutet, dass eine zusätzliche Vorrichtung zum (Vor-)Reinigen nicht benötigt wird, was Kosten spart. Ebenso entfällt der ansonsten notwendige Transport der gesägten Substrate in die entsprechende Anlage zur (Vor-)Reinigung, so dass Zeit gespart wird. Nach einer alternativen Ausführungsform erfolgt hingegen das Spülen in einem nachfolgend angeordneten, separaten Spülbecken einer Spülvorrichtung.

Nach einer besonders bevorzugten Ausführungsform erfolgt das Spülen während des Herausfahrens des Sägedrahts der Wafersäge aus den Zwischenräumen. Der in Ein- oder Mehrzahl vorhandene Sägedraht dient demnach als Abstandhalter, so dass die Substrate nach dem Sägen nicht zusammenkleben können. Gleichzeitig ist sichergestellt, dass der Sägespalt offen bleibt, was ein effektives Spülen ermöglicht. Das Spülen kann dabei während des Herausfahrens des Sägedrahtes, oder während einem vorübergehenden Pausieren des Herausfahrens erfolgen.

Nach einer weiteren Ausführungsform erfolgt das Spülen in Flüssigkeit und/oder mit Ultraschallunterstützung. Als Flüssigkeit kommt insbesondere kaltes oder warmes Wasser, oder eine die Slurry auflösende oder verdünnende wässrige Lösung in Betracht. Sofern vorhanden, sind die Ultraschallquellen besonders bevorzugt derart ausgerichtet, dass sie in Richtung der Zwischenräume der Substrate gerichtet sind.

Die vorstehend beschriebene Vorrichtung und das vorstehende beschriebene Verfahren erlauben eine gleichmäßige Reinigungswirkung eines Waferkamms noch in der Sägevorrichtung. Auf diese Weise wird Zeit und Reinigungsflüssigkeit eingespart. Der Spülvorgang erfolgt effektiver und wirtschaftlicher als nach dem Stand der Technik. Dabei ist die erfindungsgemäße Vorrichtung einfach aufgebaut und somit kostengünstig herstell- und betreibbar. Eine Beschädigung des weichen Trägerbereichs wird vermieden, da in diesem keine Versorgungsbohrungen einzubringen sind.

### Figurenbeschreibung

- **Figur 1**: zeigt eine Außenansicht einer bevorzugten Ausführungsform der erfindungsgemäßen Vorrichtung.
- **Figur 2**: zeigt eine Schnittansicht der Vorrichtung gemäß Figur 1.
- **Figur 3**: zeigt eine weitere Schnittansicht der Vorrichtung gemäß Figur 1 und 2 mit einem Substratblock.
- **Figur 4**: zeigt eine Ausführungsform der erfindungsgemäßen Vorrichtung mit anders ausgestalteter Adapterplatte.

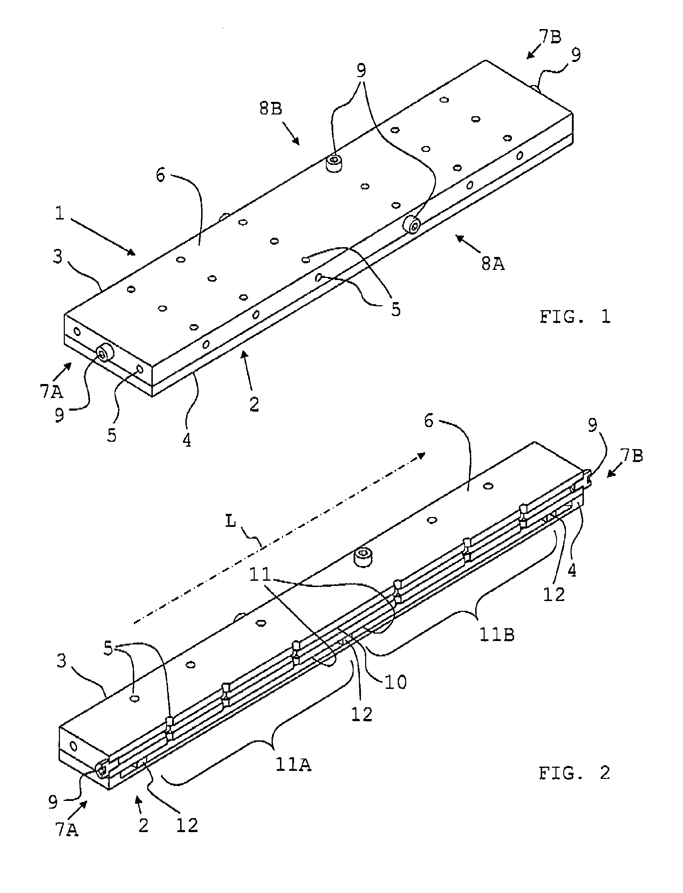

In der **Figur 1** ist die Vorrichtung nach einer bevorzugten Ausführungsform in perspektivischer Ansicht dargestellt. Die Vorrichtung weist einen als Adapterbereich 1 dienenden oberen Bereich und einen als Haltebereich 2 für einen oder mehrere Substratblöcke (nicht dargestellt) dienenden unteren Bereich auf. Vorliegend befindet sich der Adapterbereich 1 an der im Bild nach oben weisenden Seite einer als separates Bauteil vorliegenden Adapterplatte 3, und der Haltebereich 2 befindet sich an einer ebenfalls als separates Bauteil vorliegenden Halteplatte 4. Die Figur zeigt ferner eine Vielzahl von Versorgungsöffnungen 5 (nur teilweise mit Bezugszeichen versehen). Die Versorgungsöffnungen 5 sind vorliegend sowohl an der oberen Flachseite 6, an der vorderen und hinteren Stirnseite 7A, 7B, als auch an der rechten und linken Seite 8A, 8B der Vorrichtung angeordnet. Sämtliche Versorgungsöffnungen 5 befinden sich in dem Adapterbereich 1 bzw. in der Adapterplatte 3. Einige der Versorgungsöffnungen 5 sind mittels Verschlussschrauben 9 verschlossen.

In der **Figur 2** ist eine entlang der Vorrichtungs-Längsachse L (strichpunktierter Pfeil) verlaufende Schnittansicht der vorstehend beschriebenen Vorrichtung zu sehen. Gut zu erkennen ist die Funktion der an den Stirnseiten 7A, 7B angeordneten Verschlussschrauben 9. Diese verschließen einen vorliegend die gesamte Vorrichtung durchziehenden Kanal 10, der Teil eines verzweigten Kanalsystems ist. Dieses, und somit der Kanal 10, ist mit Spülflüssigkeit (nicht dargestellt) durch die Versorgungsöffnungen 5 (in Fig. 2 teilweise ohne Bezugszeichen) speisbar. Die dargestellte Ausführungsform ist nur zur Illustration mit wenigen Verschlussschrauben 9 versehen; im Normalfall sind die meisten der verschließbaren Versorgungsöffnungen 5 auch tatsächlich verschlossen, so dass die Spülflüssigkeit nicht an unerwünschter Stelle austreten kann.

Wie ersichtlich, ist ein Teil des Kanalsystems in Form des Kanals 11 auch im Haltebereich 2 bzw. in der Halteplatte 4 vorhanden. Dort ist es vorliegend über den Kanal 10 und über Versorgungsöffnungen 5, die sich in der oberen Flachseite 6 der Adapterplatte 3 befinden, speisbar. Dieser Teil des Kanalsystems, also der Kanal 11, weist zwei Abschnitte 11A, 11B auf. Je nach Lage der Verschlussschrauben 9 sind diese getrennt voneinander speisbar. Zur Bildung dieser beiden Abschnitte 11A, 11B sind in dem entsprechenden Teil des Kanalsystems (Kanal 11) flüssigkeitshemmende oder flüssigkeitsblockierende, lösbar im Kanalsystem eingebrachte Barrieren 12 vorhanden. Mit diesen ist der Kanal 11, welcher die Vorrichtung zunächst nahezu vollständig durchzieht, entsprechend unterteilbar. Die Position der Barrieren 12 ist beim Zusammenbau der Vorrichtung je nach Anforderung flexibel bestimmbar.

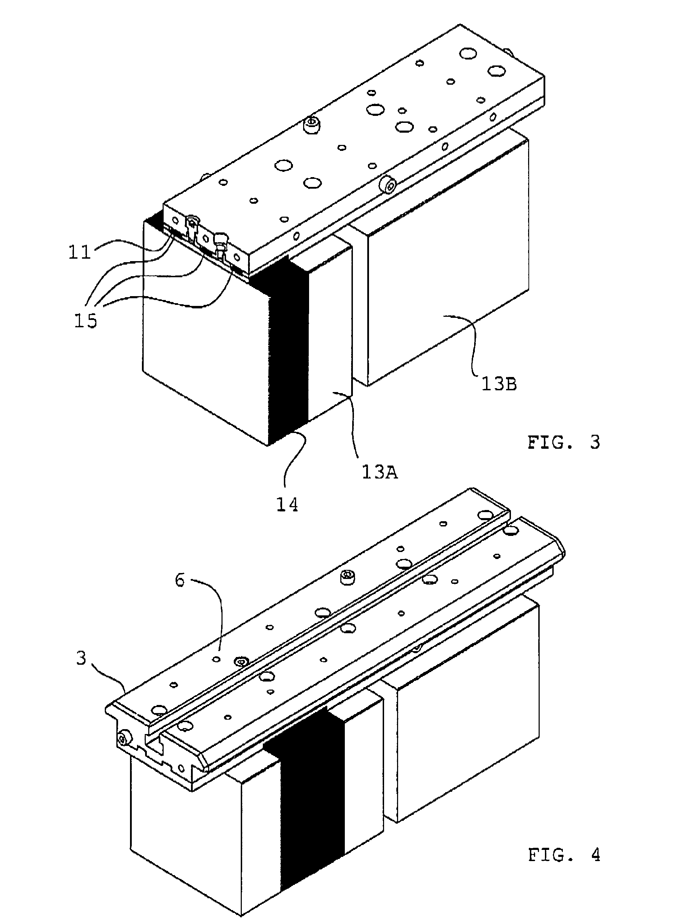

In der **Figur 3** ist eine Frontal-Schnittansicht der Vorrichtung gemäß Figur 1 und 2 gezeigt. Zudem sind zwei Substratblöcke 13A, 13B dargestellt, welche hängend an der erfindungsgemäßen Vorrichtung angeordnet sind. Der hintere Substratblock 13B liegt noch ungesägt vor, der vordere Substratblock 13A ist bereits teilweise in einzelne Substrate 14 gesägt (Bereich mit schwarzer Seitenfläche). Wie aus der Figur 3 ersichtlich, befinden sich im Kanal 11 nunmehr Durchtrittsöffnungen 15. Die Durchtrittsöffnungen 15 wurden im Rahmen des Sägens des Substratblocks 13A in die Substrate 14 mittels eines Sägedrahtes (nicht gezeigt) hergestellt. Wird das Kanalsystem mittels Spülflüssigkeit (nicht dargestellt) beaufschlagt, indem es über die Versorgungsöffnungen (ohne Bezugszeichen) gespeist wird, tritt die Spülflüssigkeit aus den Durchtrittsöffnungen 15 aus. Von dort aus strömt sie in den Bereich der Zwischenräume der Substrate 14, wo sie eventuell vorhandene Slurry ausspült. Da die Zwischenräume nach den Seiten und nach unten hin offen sind, kann die mit Slurry beladene Spülflüssigkeit ungehindert abfließen.

Gemäß der **Figur 4** kann die Adapterplatte 3 auch anders als vorstehend dargestellt ausgestaltet sein. Sie kann, wie gezeigt, eine Aufnahmeschiene 16 aufweisen, mit der die Vorrichtung mit einer maschinellen Einrichtung verbindbar ist (nicht dargestellt). Es ist klar, dass je nach konkreter Ausgestaltung der maschinellen Einrichtung auch eine andere als die gezeigte Geometrie der oberen Flachseite 6 der Adapterplatte 3 vorgesehen sein kann.

### Bezugszeichenliste

- 1: Adapterbereich
- 2: Haltebereich
- 3: Adapterplatte
- 4: Halteplatte
- 5: Versorgungsöffnungen
- 6: obere Flachseite
- 7A: vordere Stirnseite
- 7B: hintere Stirnseite
- 8A: rechte Seite
- 8B: linke Seite
- 9: Verschlussschraube
- 10: Kanal
- 11: Kanal, (Haupt-)Kanal
- 11A: erster Abschnitt, (Sub-)Kanal
- 11B: zweiter Abschnitt, (Sub-)Kanal
- 12: Barriere
- 13A: Substratblock
- 13B: Substratblock
- 14: Substrat
- 15: Durchtrittsöffnungen
- 16: Aufnahmeschiene
- L: Vorrichtungs-Längsachse

## Patentansprüche

1. Vorrichtung zum Halten eines zu sägenden Substratblocks (13A, 13B) und zum Spülen der durch das Sägen des Substratblocks (13A, 13B) entstandenen Zwischenräume mit zwei parallel zur Vorrichtungs-Längsachse (L) und übereinander angeordneten Bereichen, wobei der obere Bereich als Adapterbereich (1) ausgestaltet ist, über den die Vorrichtung mit einer maschinellen Einrichtung verbindbar ist, und wobei der untere Bereich als Haltebereich (2) ausgebildet ist, der einen als Kanal (11) vorliegenden Teil eines über verschließbare Versorgungsöffnungen (5) mit Spülflüssigkeit speisbaren und umlaufend geschlossenen oder verschließbaren Kanalsystems aufweist, wobei der Boden des Kanals (11) beim Sägen des Substratblocks (13A, 13B) unter Schaffung von Durchtrittsöffnungen (15) für die Spülflüssigkeit schlitzartig geöffnet wird, und wobei der Kanal (11) entlang der Vorrichtungs-Längsachse (L) in mehrere Abschnitte (11A, 11B) unterteilt ist.

2. Vorrichtung nach Anspruch 1, bei der die Abschnitte (11A, 11B) des Kanals (11) entlang der Vorrichtungs-Längsachse (L) unabhängig voneinander mit Spülflüssigkeit speisbar sind.

3. Vorrichtung nach Anspruch 1 oder 2, bei der der Kanal (11) durch mehrere baulich getrennte und unabhängig voneinander speisbare Kanäle unterteilt ist.

4. Vorrichtung nach Anspruch 1 oder 2, bei der der Kanal (11) durch mehrere, im Kanal (11) lösbar eingebrachte Barrieren (12) unterteilt ist.

5. Vorrichtung nach einem der Ansprüche 1 bis 4, bei der die verschließbaren Versorgungsöffnungen (5) an der oberen Flachseite (6) des Adapterbereichs (1) angeordnet sind.

6. Vorrichtung nach einem der Ansprüche 1 bis 4, bei der die verschließbaren Versorgungsöffnungen (5) an der umlaufenden
Seite (7A, 7B, 8A, 8B) des Adapterbereichs (1) angeordnet sind.

7. Vorrichtung nach einem der vorhergehenden Ansprüche, wobei der Haltebereich (2) als Halteplatte (4) und der Adapterbereich (1) als Adapterplatte (3) ausgebildet sowie beide Platten (3, 4) lösbar miteinander verbunden sind.

8. Vorrichtung nach einem der vorhergehenden Ansprüche, wobei das Material des Haltebereichs (2) aus der Gruppe bestehend aus Glas, Kunststoff, Epoxid, Keramik, Metall, sowie Mischungen davon ausgewählt ist.

9. Verfahren zum Spülen der durch das Sägen eines Substratblocks (13A, 13B) entstandenen Zwischenräume unter Verwendung einer Vorrichtung gemäß einem der Ansprüche 1 bis 8, bei dem eine Beaufschlagung des Kanalsystems mit einer Spülflüssigkeit und ein Austritt derselben aus den Durchtrittsöffnungen (15) erfolgt.

10. Verfahren zum Spülen der durch das Sägen eines Substratblocks (13A, 13B) entstandenen Zwischenräume unter Verwendung einer Vorrichtung mit zwei parallel zur Vorrichtungs-Längsachse (L) und übereinander angeordneten Bereichen, wobei der obere Bereich als Adapterbereich (1) ausgestaltet ist, über den die Vorrichtung mit einer maschinellen Einrichtung verbindbar ist, und wobei im unteren Bereich, der als Haltebereich (2) ausgebildet ist, ein als Kanal (11) mit mehreren, in Vorrichtungs-Längsachse (L) verlaufenden Abschnitten (11A, 11B) vorliegender Teil eines umlaufend geschlossenen Kanalsystems angeordnet ist, umfassend die Schritte
- Speisen des Kanalsystems mit Spülflüssigkeit über im oberen Bereich angeordnete, verschließbare Versorgungsöffnungen (5);
- Spülen der Zwischenräume mittels schlitzartiger Durchtrittsöffnungen (15), welche beim Sägen des Substratblocks (13A, 13B) im Boden des Kanals (11) geschaffen worden sind.

11. Verfahren nach Anspruch 9 oder 10, wobei das Spülen aus den mit Spülflüssigkeit gespeisten Durchtrittsöffnungen (15) entlang der Vorrichtungs-Längsachse (L) gleichmäßig erfolgt.

12. Verfahren nach einem der Ansprüche 9 bis 11, wobei die Speisung des Kanals (11) und das Spülen der Zwischenräume in Vorrichtungs-Längsachse (L) gesehen abschnittsweise erfolgt.

13. Verfahren nach einem der Ansprüche 9 bis 12, wobei das Spülen im Arbeitsbereich einer Trennvorrichtung für den Substratblock (13A, 13B) erfolgt.

14. Verfahren nach einem der Ansprüche 9 bis 13, wobei das Spülen in Flüssigkeit und/oder mit Ultraschallunterstützung erfolgt.
